# EUROPÄISCHE PATENTANMELDUNG

(11) **EP 0 905 522 A2**
(43) Veröffentlichungstag der Anmeldung: **31.03.1999**
(21) Anmeldenummer: 98114549.3
(22) Anmeldetag: 03.08.1998
(51) Int. Cl.: G01R 33/032, G01R 15/24, G01J 4/04

(54) **Anordnung zum Messen einer Messgrösse aus einem vorgegebenen Messbereich**

(30) Priorität: 30.09.1997 DE 19743252
(71) Anmelder: SIEMENS AKTIENGESELLSCHAFT, 80333 München (DE)
(72) Erfinder: Bosselmann, Thomas, 91054 Erlangen (DE)

(57) **Zusammenfassung**

Bei der Anordnung zum Messen einer Meßgröße (I) werden zur Erhöhung der Meßauflösung (MA) eines Meßsignals (M₁) ein periodisches zweites Meßsignal (M₂) und erfindungsgemäß ein periodisches weiteres zweites Meßsignal (M₂') abgeleitet und ein drittes Meßsignal (M₃) aus dem ersten Meßsignal (M₁) und dem zweiten und/oder weiteren zweiten Meßsignal (M₂, M₂ʼ) ableitet.

## Beschreibung

Die Erfindung betrifft eine Anordnung zum Messen einer Meßgröße aus einem vorgegebenen Meßbereich nach dem Oberbegriff des Anspruchs 1.

Eine Anordnung der genannten Art ist aus der WO 97/20222 (GR 95 P 3844 DE) bekannt. Diese Anordnung ermöglicht eine Erhöhung der Meßauflösung über die des ersten Meßsignals hinaus unter Beibehaltung des Meßbereichs des ersten Meßsignals oder eine Erweiterung des Meßbereichs des ersten Meßsignals unter Beibehaltung der Meßauflösung des ersten Meßsignals. Die Meßauflösung dieser Anordnung ist durch das zweite Meßsignal bestimmt, schwankt aber zwischen der höchsten Auflösung des zweiten Meßsignals und der relativ geringeren Auflösung des ersten Meßsignals. Diese bekannte Anordnung ist nicht inkremental.

Aus der EP-B-O 208 593 ist eine Anordnung zum Messen einer Meßgröße in Form eines magnetooptischen Stromwandlers bekannt, bei dem linear polarisiertes Meßlicht nach Durchlaufen einer einen Stromleiter umgebenden Faraday-Lichtleitfaser von einem Strahlteiler in zwei Lichtteilsignale aufgeteilt wird und jedes dieser Lichtteilsignale einem Analysator zugeführt wird. Die Eigenachsen der beiden Analysatoren sind unter einem Winkel von 0° bzw. 45° zur Einkoppelpolarisation des Meßlichts gerichtet. Dadurch wird am Ausgang eines Analysators ein erstes sinusförmiges Signal und am Ausgang des anderen Analysators ein zweites cosinusförmiges Signal erhalten. Diese beiden Signale jeweils mehrdeutige oszillierende Funktionen des Stroms im Stromleiter, die um 90° gegeneinander phasenverschoben sind.

Aus diesen beiden mehrdeutigen Signalen wird ein eindeutiges Meßsignal zusammengesetzt durch Vergleich der Vorzeichen und der Beträge der Meßwerte des ersten sinusförmigen Signals und des zweiten cosinusförmigen Signals. Sobald die Beträge von Sinus und Cosinus gleich sind, d.h. bei einem ganzzahligen Vielfachen von 45°, wird in Abhängigkeit von den Vorzeichen von Sinus und Cosinus von einem eindeutigen Zweig des ersten sinusförmigen Signals in einen eindeutigen Zweig des cosinusförmigen Signals umgeschaltet oder umgekehrt.

Dieses Verfahren ist ein Inkrementales Verfahren, so daß der Arbeitspunkt bei Strom null bei einem Ausfall der Elektronik des Stromwandlers erst wieder neu eingestellt werden muß.

Aus der DE-A-39 315 42 (GR 89 P 8587 DE) ist ein optischer Magnetfeldsensor bekannt, mit dem eine durch eine elliptische Polarisation des Meßstrahls hervorgerufene Verfälschung des Meßergebnisses weitgehend vermieden werden kann. Wesentlicher Teil dieses Sensors ist eine Analysatoreinrichtung zur vollständigen Polarisationsanalyse, bei der von einem durch eine magnetfeld-empfindliche Meßstrecke transmittierten Lichtstrahl drei Meßstrahlen abgetrennt werden, die jeweils einem Polarisationsstrahlteiler zugeführt werden. Dabei ist wenigstens einem Polarisationsstrahlteiler eine λ/4-Platte vorgeschaltet. Die komplette Information über den Polarisationszustand läßt sich aus den Intensitäten der aus den Polarisationsstrahlteilern austretenden polarisierten Teilstrahlen ermitteln. Mit dieser Anordnung ist eine Bestimmung des Polarisationszustandes ohne mechanisch bewegliche Teile möglich.

Besonders einfache Verhältnisse für die Ermittlung des Polarisationszustandes aus den Intensitäten der Teilstrahlen ergeben sich dann, wenn die λ/4-Platte und der ihr nachgeschaltete Polarisationsstrahlteiler bezüglich ihrer Hauptachsen um 45° zueinander gekreuzt sind. Die beiden anderen Polarisationsstrahlteiler sind vorzugsweise ebenfalls zueinander um 45° gekreuzt, wobei die Lage der Hauptachsen eines dieser Polarisationsstrahlteiler vorzugsweise mit der Lage der Hauptachsen des der λ/4-Platte nachgeschalteten Polarisationsstrahlteilers übereinstimmt.

Der Erfindung liegt die Aufgabe zugrunde, eine Anordnung der eingangs genannten Art dahingehend zu verbessern, daß die Erhöhung der Meßauflösung über die des ersten Meßsignals hinaus unter Beibehaltung des Meßbereichs des ersten Meßsignals stets bei einer erhöhten Meßauflösung ermöglicht ist, die größer als die relativ geringere Auflösung des ersten Meßsignals ist.

Diese Aufgabe wird durch die im kennzeichnenden Teil des Patentanspruchs 1 angegebenen Merkmale gelöst.

Bei der erfindungsgemäßen Anordnung besteht vorteilhafterweise die Möglichkeit, daß in dem Fall einer minimalen Meßauflösung des einen weiteren Signals eine größere Meßauflösung des anderen weiteren zweiten Meßsignals zur Verfügung steht, wenn dieses weitere zweite Meßsignals geeignet gewählt wird. Es braucht dann nur beispielsweise auf das weitere zweite Meßsignal umgeschaltet zu werden, wenn die Meßauflösung des einen zweiten Meßsignals minimal wird, und das dritte Meßsignal mit diesem weiteren zweiten Meßsignal gebildet zu werden. Umgekehrt kann wieder auf das eine zweite Meßsignal umgeschaltet werden, wenn die Meßauflösung des weiteren zweiten Meßsignals minimal wird, und das dritte Meßsignal wieder mit diesem einen zweiten Meßsignal gebildet werden.

Bei der erfindungsgemäßen Anordnung ist auch eine Erweiterung des Meßbereichs des ersten Meßsignals unter Beibehaltung der größeren Meßauflösung des zweiten und weiteren zweiten Meßsignals ermöglicht.

Es ist vorteilhafterweise auch möglich, die beiden zweiten Meßsignale durch einen geeigneten Algorithmus derart zu einem einzigen neuen zweiten Meßsignal miteinander zu verknüpfen, daß die Meßauflösung des neuen zweiten Meßsignals stets größer als die minimale Meßauflösung des einen und weiteren zweiten Meßsignals ist. Das dritte Meßsignal kann in diesem Fall mit dem neuen zweiten Meßsignal und dem ersten Meßsignal gebildet werden.

Die erfindungsgemäße Anordnung ist vorteilhafterweise weiterhin nicht inkremental.

Bevorzugter- und vorteilhafterweise ist die Periode des weiteren zweiten Meßsignals gleich der Periode des einen zweiten Meßsignals gewählt (Anspruch 2).

Besonders vorteilhaft ist es, die beiden zweiten Meßsignale gleich aber gegeneinander phasenverschoben zu wählen (Anspruch 3).

Vorzugsweise ist eine Anordnung nach Anspruch 3 zum Messen eines elektrischen Stromes aus einem vorgegebenen Strommeßbereich in einem Stromleiter eingesetzt, wobei diese Anordnung dann vorteilhafterweise so ausgebildet ist, wie es im Anspruch 4 angegeben ist.

Ein Verfahren zum Betrieb einer erfindungsgemäßen Anordnung ist im Anspruch 5 angegeben.

Die Erfindung wird in der nachfolgenden Beschreibung anhand der Figuren beispielhaft näher erläutert. Es zeigen:
- Figur 1: in schematischer Darstellung ein Ausführungsbeispiel einer erfindungsgemäßen Anordnung,
- Figur 2: in schematischer Darstellung ein Ausführungsbeispiel einer in der zweiten Auswerteeinheit des Beispiels nach Figur 1 verwendeten erfindungsgemäßen Polarisationsstrahlteileranordnung,
- Figur 2a: eine Anordnung der Polarisationsstrahlteiler nach Figur 2, und
- Figur 3: ein Diagramm, welches schematisch ein Beispiel für ein erstes Meßsignal, zweites Meßsignal und weiteres zweites Meßsignal zeigt.

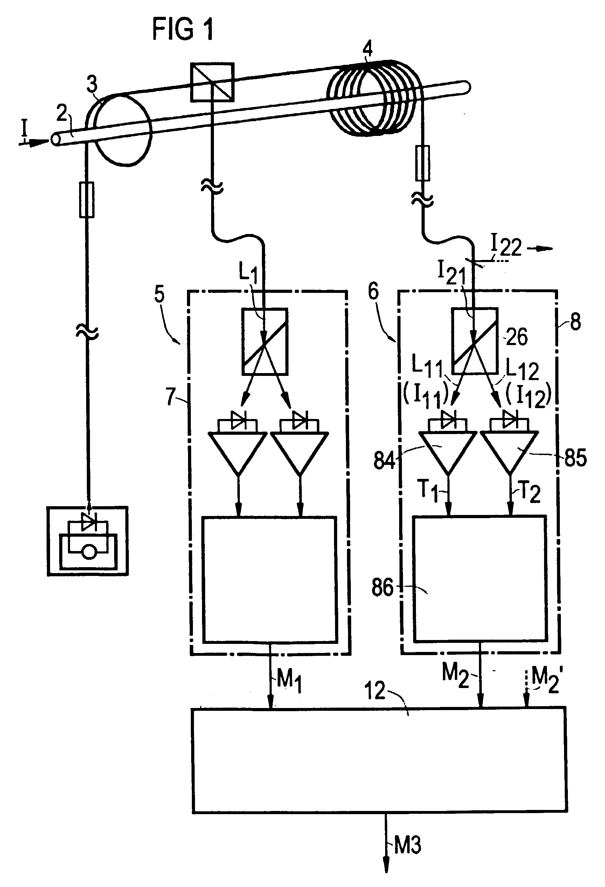

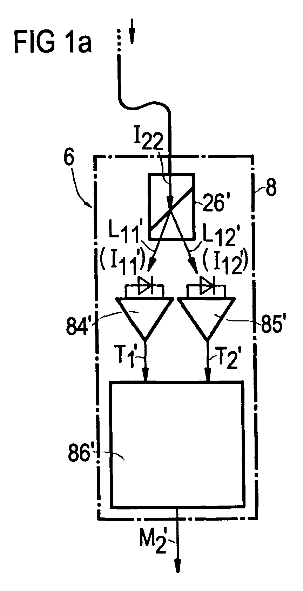

Das Beispiel nach Figur 1 ist eine Anordnung zum Messen eines elektrischen Stromes I aus einem vorgegebenen Strommeßbereich MR in einem Stromleiter 2, die auf der Anordnung nach Figur 4 und der dazugehörigen Beschreibung der WO 97/20222 basiert.

Die auf zwei Blatt Zeichnungen verteilte Anordnung nach Figur 1 weist eine erste Meßeinrichtung 5 auf, die ein erstes, den Stromleiter 2 umgebendes Faraday-Element 3 und eine erste Auswerteeinheit 7 aufweist. Die erste Auswerteeinheit 7 leitet aus einer Drehung der Polarisationsebene eines ersten linear polarisierten Lichtsignals L₁ nach dessen wenigsten einmaligem Durchlaufen des ersten Faraday-Elements 3 das erste Meßsignal M1 für den die Meßgröße bildenden Strom I ab.

Eine zweite Meßeinrichtung 6 weist ein zweites, den Stromleiter 2 umgebendes Faraday-Element 4 und eine zweite Auswerteeinheit 8 auf. Die zweite Auswerteeinheit 8 leitet aus einer Drehung der Polarisationsebene eines zweiten linear polarisierten Lichtsignals L₂ nach dessen wenigstens einmaligem Durchlaufen wenigstens des zweiten Faraday-Elements 4 das zweite Meßsignal M₂ für den Strom I ab.

Die zweite Auswerteeinheit 8 weist einen Polarisationsstrahlteiler 26 mit einer Hauptachse auf, dem ein Intensitätsanteil L₂₁ des zweiten Lichtsignals L₂ zugeführt ist und der den zugeführten Intensitätsanteil I₂₁ in ein Paar senkrecht zueinander polarisierter Lichtstrahlen L₁₁, L₁₂ aufspaltet, die einer Einrichtung 84, 85, 86 zur Erzeugung des zweiten Meßsignals M₂ aus den Intensitäten I₁₁, I₁₂ der beiden Lichtstrahlen L₁₁, L₁₂ zugeführt sind.

Insoweit stimmt die Anordnung nach Figur 1 mit der Anordnung nach Figur 4 der Anordnung nach der WO 97/20222 überein, auf die bezüglich hier nicht beschriebener sonstiger Teile der bekannten Anordnung verwiesen wird.

Erfindungsgemäß weist die zweite Auswerteeinrichtung 8 einen aus dem zweiten Zeichnungsblatt hervorgehenden weiteren Polarisationsstrahlteiler 26' mit einer Hauptachse auf, dem ein Intensitätsanteil I₂₂ des zweiten Lichtsignals L₂ zugeführt ist und der diesen zugeführten Intensitätsanteil I₂₂ in ein weiteres Paar senkrecht zueinander polarisierter Lichtstrahlen L₁₁ʼ, L₁₂ʼ aufspaltet, die einer Einrichtung 84', 85', 86' zur Erzeugung des weiteren zweiten Meßsignals M₂ʼ aus den Intensitäten I₁₁', I₁₂' der beiden Lichtstrahlen L₁₁', L₁₂ʼ zugeführt sind.

Die beiden Polarisationsstrahlteiler 26, 26' sind überdies derart relativ zueinander verdreht sind, daß ihre Hauptachsen in einem Winkel von 45° relativ zueinander angeordnet sind.

Eine Signalverarbeitungseinheit 12 der erfindungsgemäßen Anordnung nach Figur 1 ist so ausgebildet, daß das im vorgegebenen Meßbereich MR eine eindeutige Funktion des Stroms I bildende und wenigstens die gleiche Meßauflösung wie das zweite Meßsignal M₂ aufweisende dritte Meßsignal M₃ aus dem ersten Meßsignal M₁ und dem zweiten Meßsignal M₂ und/oder weiteren zweiten Meßsignal M₂ʼ abgeleitet wird.

Dabei besteht die Möglichkeit der wahlweisen Umschaltung von einem der beiden zweiten Meßsignale M₂ oder M₂' zum andern und/oder der Bildung eines neuen zweiten Meßsignals aus den beiden zugeführten zweiten Meßsignalen M₂ und M₂' nach einem vorgebbaren Algorithmus.

Der in Figur 1 dargestellten erfindungsgemäßen Anordnung liegt die Anordnung nach Figur 4 der WO 97/20222 zugrunde.

Ebensogut kann die Anordnung nach Figur 7 der WO 97/20222 in gleicher Weise als Basis für eine erfindungsgemäße Anordnung zum Messen eines elektrischen Stromes I aus einem vorgegebenen Strommeßbereich MR in einem Stromleiter 2 genommen werden.

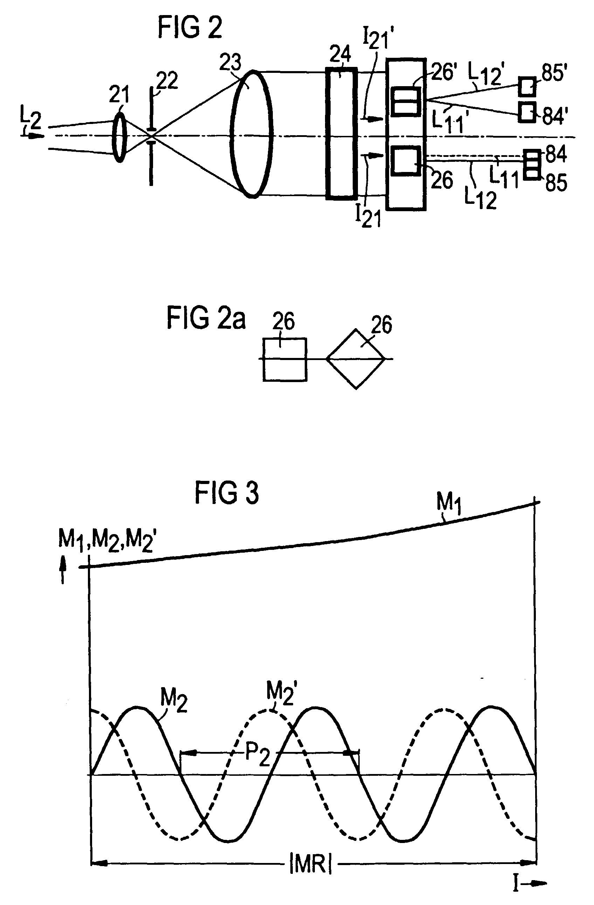

Die Figur 2 zeigt eine zweckmäßige Polarisationsstrahlteileranordnung, die in der zweiten Auswerteeinheit 8 einer erfindungsgemäßen Anordnung zum Messen eines elektrischen Stromes I aus einem vorgegebenen Strommeßbereich MR in einem Stromleiter 2 vorteilhaft verwendet werden kann.

Die Anordnung nach Figur 2 weist ein Fokussierungsobjektiv 21 auf, welches das zweite Lichtsignal L₂ über eine Lochblende 22 auf eine Kollimatorlinse 23 projiziert. Das von der Kollimatorlinse 23 parallel gebündelte zweite Lichtsignal L₂ beleuchtet eine Zylinderlinse 24, die das zweite Lichtsignal L₂ auf die beiden Polarisationsstrahlteiler 26 und 26' der zweiten Auswerteeinheit 8 bündelt. Jeder Polarisationsstrahlteiler 26 und 26' spaltet den ihm zugeführten Intensitätsanteil I₂₁ bzw. I₂₁' jeweils in zwei senkrecht zueinander polarisierte Lichtstrahlen L₁₁ und L₁₂ bzw. L₁₁' und L₁₂ʼ auf, die der jeweiligen Einrichtung 84, 85, 86 bzw. 84', 85', 86' zur Erzeugung des zweiten Meßsignals M₂ bzw. weiteren zweiten Meßsignals M₂' aus den Intensitäten I₁₁, I₁₂ bzw. I₁₁', I₁₂' der beiden Lichtstrahlen L₁₁, L₁₂ bzw. L₁₁', L₁₂' zugeführt sind.

Die Einrichtung 84, 85, 86 zur Erzeugung des zweiten Meßsignals M₂ weist einen optischen Detektor 84 zum Empfang des Lichtstrahls L₁₁ und Erzeugen eines der Intensität I₁₁ dieses Lichtstrahls L₁₁ proportionalen elektrischen Signals T₁₁ und einen optischen Detektor 85 zum Empfang des Lichtstrahls L₁₂ und Erzeugen eines der Intensität I₁₂ dieses Lichtstrahls L₁₂ proportionalen elektrischen Signals T₁₂ sowie elektronische Mittel 86 zum Ableiten dieses zweiten Meßsignals M₂ aus diesen Signalen T₁₁ und T₁₂ auf. Die Einrichtung 84', 85', 86' zur Erzeugung des weiteren zweiten Meßsignals M₂' weist einen optischen Detektor 84' zum Empfang des Lichtstrahls L₁₁' und Erzeugen eines der Intensität I₁₁' dieses Lichtstrahls L₁₁' proportionalen elektrischen Signals T₁₁' und einen optischen Detektor 85' zum Empfang des Lichtstrahls L₁₂' und Erzeugen eines der Intensität I₁₂' dieses Lichtstrahls L₁₂' proportionalen elektrischen Signals T₁₂ʼ sowie elektronische Mittel 86' zum Ableiten des weiteren zweiten Meßsignals M₂' aus diesen Signalen T₁₁' und T₁₂' auf.

Die vorteilhafte relative Anordnung der erfindungsgemäßen Polarisationsstrahlteiler 26 und 26' bezüglich ihrer Hauptachsen ist in der Figur 2a angedeutet. Die beiden Polarisationsstrahlteiler 26 und 26' sind derart relativ zueinander verdreht sind, daß ihre Hauptachsen in einem Winkel von 45° relativ zueinander gekreuzt sind. Dadurch werden zwei zweite Meßsignale M₂ und M₂' erhalten, die um 90° phasenverschoben und bestens für eine erfindungsgemäße Anordnung geeignet sind.

In der Figur 3 sind ein erstes Meßsignal M₁ und zwei derartige zweite Meßsignale M₂ und M₂' beispielhaft und schematisch dargestellt.

## Patentansprüche

1. Anordnung zum Messen einer Meßgröße (I) aus einem vorgegebenen Meßbereich (MR) mit
- einer ersten Meßeinrichtung (5) zum Erzeugen eines ersten Meßsignals (M₁), das eine über dem vorgegebenen Meßbereich (MR) eindeutige Funktion der Meßgröße (I) ist,
- einer zweiten Meßeinrichtung (6) zum Erzeugen eines zweiten Meßsignals (M₂), das eine periodische Funktion der Meßgröße (I) ist mit einer Periode (P₂), die kleiner als die doppelte Intervallänge (|MR|) des Meßbereichs (MR) ist, und
- einer mit den beiden Meßeinrichtungen (5, 6) verbundenen Signalverarbeitungseinheit (12), die aus dem ersten Meßsignal (M₁) und dem zweiten Meßsignal (M₂) ein drittes Meßsignal (M₃) ableitet, das im vorgegebenen Meßbereich (MR) eine eindeutige Funktion der Meßgröße (I) ist und wenigstens die gleiche Meßauflösung wie das zweite Meßsignal (M₂) aufweist, **dadurch gekennzeichnet,** daß
- die zweite Meßeinrichtung (6) ein weiteres zweites Meßsignal (M₂') erzeugt, das eine periodische Funktion der Meßgröße (I) ist mit einer Periode (P₂'), die kleiner als die doppelte Intervallänge (|MR|) des Meßbereichs (MR) ist, und mit einer größeren Meßauflösung (MA) dort, wo eine Meßauflösung (MA) des einen weiteren Meßsignals (M₂) minimal ist, und daß
- die Signalverarbeitungseinheit (12) das im vorgegebenen Meßbereich (MR) eine eindeutige Funktion der Meßgröße (I) bildende und wenigstens die gleiche Meßauflösung wie das zweite Meßsignal (M₂) aufweisende dritte Meßsignal (M₃) aus dem ersten Meßsignal (M₁) und dem zweiten und/oder weiteren zweiten Meßsignal (M₂, M₂') ableitet.

2. Anordnung nach Anspruch 1, **dadurch gekennzeichnet,** daß die Periode (P₂') des weiteren zweiten Meßsignals (M₂') gleich der Periode (P₂) des einen zweiten Meßsignals (M₂) ist.

3. Anordnung nach Anspruch 2, **dadurch gekennzeichnet,** daß die beiden zweiten Meßsignale (M₂, M₂') gleich aber gegeneinander phasenverschoben sind.

4. Anordnung nach Anspruch 3 zum Messen eines elektrischen Stromes (I) aus einem vorgegebenen Strommeßbereich (MR) in einem Stromleiter (2), bei der
- die erste Meßeinrichtung (5) ein erstes, den Stromleiter (2) umgebendes Faraday-Element (3) und eine erste Auswerteeinheit (7) aufweist, die aus einer Drehung der Polarisationsebene eines ersten linear polarisierten Lichtsignals (L₁) nach dessen wenigsten einmaligem Durchlaufen des ersten Faraday-Elements (3) das erste Meßsignal (M1) für den Strom (I) ableitet,
- die zweite Meßeinrichtung (6) wenigstens ein zweites, den Stromleiter (2) umgebendes Faraday-Element (4) und eine zweite Auswerteeinheit (8) aufweist, die aus einer Drehung der Polarisationsebene eines zweiten linear polarisierten Lichtsignals (L₂) nach dessen wenigstens einmaligem Durchlaufen wenigstens des zweiten Faraday-Elements (4) das zweite Meßsignal (M₂) für den Strom (I) ableitet, wobei
- die zweite Auswerteeinheit (8) einen Polarisationsstrahlteiler (26) mit einer Hauptachse () aufweist, dem ein Intensitätsanteil (L₂₁) des zweiten Lichtsignals (L₂) zugeführt ist und der den zugeführten Intensitätsanteil (L₂₁) in ein Paar senkrecht zueinander polarisierter Lichtstrahlen (L₁₁, L₁₂) aufspaltet, die einer Einrichtung (84, 85, 86) zur Erzeugung des zweiten Meßsignals (M₂) aus den Intensitäten (I₁₁,I₁₂) der beiden Lichtstrahlen (L₁₁, L₁₂) zugeführt sind, **dadurch gekennzeichnet,** daß die zweite Auswerteeinrichtung (8)
- einen weiteren Polarisationsstrahlteiler (26') mit einer Hauptachse () aufweist, dem ein Intensitätsanteil (I₂₂) des zweiten Lichtsignals (L₂) zugeführt ist und der diesen zugeführten Intensitätsanteil (I₂₂) in ein weiteres Paar senkrecht zueinander polarisierter Lichtstrahlen (L₁₁', L₁₂') aufspaltet, die einer Einrichtung (84', 85', 86') zur Erzeugung des weiteren zweiten Meßsignals M₂ʼ aus den Intensitäten (I₁₁', I₁₂') der beiden Lichtstrahlen (L₁₁ʼ, L₁₂ʼ) zugeführt sind, wobei
- die beiden Polarisationsstrahlteiler (26, 26') derart relativ zueinander verdreht sind, daß ihre Hauptachsen in einem Winkel von 45° relativ zueinander angeordnet sind.

5. Verfahren zum Betrieb einer Anordnung nach einem der vorhergehenden Ansprüche, **dadurch gekennzeichnet,** daß
- das dritte Meßsignal (M₃) mit dem ersten Meßsignal (M₁) und einem (M₂; M₂,) der beiden zweiten Meßsignale (M₂, M₂') gebildet wird,
- auf das andere zweite Meßsignal (M₂'; M₂) umgeschaltet wird, wenn die Meßauflösung (MA₂) des einen zweiten Meßsignals (M2; M2') vorgebbaren minimalen Wert (MAₘᵢₙ) erreicht, und
- danach das dritte Meßsignal (M₃) mit dem ersten Meßsignal (M₁) und dem anderen zweiten Meßsignale (M₂'; M₂) gebildet wird.
